**Europäisches Patentamt**

**European Patent Office**

**Office européen des brevets**

(19)

(11) Veröffentlichungsnummer : **0 079 848**
**B1**

(12)

# EUROPÄISCHE PATENTSCHRIFT

(45) Veröffentlichungstag der Patentschrift :
09.09.87

(51) Int. Cl.⁴ : **H 05 K 13/04**

(21) Anmeldenummer : **82730132.6**

(22) Anmeldetag : **04.11.82**

(54) **Vorrichtung zum Auslöten elektronischer Bauteile aus Leiterplatten.**

(30) Priorität : **12.11.81 IL 64277**

(43) Veröffentlichungstag der Anmeldung :
**25.05.83 Patentblatt 83/21**

(45) Bekanntmachung des Hinweises auf die Patenterteilung : **09.09.87 Patentblatt 87/37**

(84) Benannte Vertragsstaaten :
**AT BE CH DE FR GB IT LI LU NL SE**

(56) Entgegenhaltungen :
**DE-A- 2 655 773**
**DE-A- 2 925 347**
**DE-B- 1 943 393**
**US-A- 3 644 980**

(73) Patentinhaber : **ERSA Ernst Sachs KG GmbH & Co.**
**Leonhard-Karl-Strasse 24**
**D-6980 Wertheim / Main (DE)**

(72) Erfinder : **Shtalryd, Haim**
**Branitzki 31**
**Rishon Lezion Israel 75 239 (IL)**

(74) Vertreter : **Lüke, Dierck-Wilm, Dipl.-Ing.**
**Geifertstrasse 56**
**D-1000 Berlin 33 (DE)**

## Beschreibung

Die Erfindung bezieht sich auf eine Vorrichtung zum Auslöten elektronischer Bauteile aus Leiterplatten gemäss der Gattung des Patentanspruches 1.

Das Auslöten elektronischer Bauteile aus Leiterplatten ist notwendig, um fehlerhafte oder fehlerhaft eingelötete elektronische Bauteile von der Leiterplatte wieder zu entfernen. Obwohl das Auslöten elektronischer Bauteile normalerweise nicht zum regelmässigen Herstellungsprozess von Leiterplatten gehört, tritt dies doch mit beachtlicher Häufigkeit auf. Es ist bekannt, dass das Auslöten elektronischer Bauteile aus Leiterplatten erhebliche Kosten verursacht, insbesondere weil hierfür lange Arbeitszeiten notwendig sind. Gewöhnlich wird ein ausgelötetes elektronisches Bauteil nicht wieder verwendet, so dass eine Beschädigung des elektronischen Bauteiles beim Auslöten nicht nachteilig ist. Andererseits ist es jedoch notwendig, Beschädigungen der Leiterplatte selbst und der auf diesen noch befindlichen weiteren elektronischen Bauteile beim Auslöten eines beschädigten elektronischen Bauteiles zu verhindern.

Bei einer aus der US 3.644.980 vorbekannten gattungsgemässen Vorrichtung zum Auslöten elektronischer Bauteile aus Leiterplatten wird ein auszulötendes elektronisches Bauteil mittels der federnden Greifzange dadurch festgeklemmt, dass das Gehäuse an der Zugstange entlang über einen Teil der Schenkel der federnden Greifzange geschoben wird, wodurch das Bauteil von der Greifzange eingeklemmt wird. Die Einrichtung zum Aufschmelzen der Lötstellen befindet sich unterhalb der das auszulötende Bauteil tragenden Leiterplatte und besteht aus beheizten Ringen, in welche die aufzuschmelzenden Lötstellen eingreifen. Zwischen den Rillen befindet sich als Einrichtung zum Entfernen von Lotresten aus den Bohrungen der Leiterplatte die Mündung einer Vakuumeinrichtung. Diese bekannte Vorrichtung zum Auslöten elektronischer Bauteile aus Leiterplatten ist insbesondere hinsichtlich der Anordnung und Ausbildung der Einrichtung zum Entfernen von Lotresten aus den Bohrungen der Leiterplatte in Form einer Vakuumeinrichtung äusserst aufwendig und erfordert insbesondere eine ganz spezielle Ausbildung der Einrichtung zum Aufschmelzen der Lötstellen.

Es ist darüber hinaus aus « Western Electric-Technical Digest Nr. 33 », Januar 1974, Seiten 25 und 26 eine gattungsfremde Vorrichtung zum Auslöten elektronischer Bauteile aus Leiterplatten bekannt, bei welcher die Einrichtung zum Aufschmelzen der Lötstellen aus einem unterhalb der Leiterplatte angeordneten, eine Lötwelle bildenden Lötbadbehälter besteht und bei welcher als Abzieheinrichtung und Einrichtung zum Entfernen von Lotresten aus den Bohrungen der Leiterplatte ein Saugluft/Druckluft-Kopf dichtend auf die Oberseite der Leiterplatte aufgesetzt wird, welcher nach dem Aufschmelzen der Lötstellen das elektronische Bauteil unter Einwirkung eines Unterdrucks von der Leiterplatte abzieht. Nach dem Abheben des Kopfes und Entfernen des abgezogenen Bauteils wird der Kopf wieder auf die Leiterplatte dichtend aufgesetzt und unter Wirkung von durch den Kopf strömender Druckluft werden die Bohrungen in der Leiterplatte von Lotresten befreit. Diese bekannte Vorrichtung erfordert einerseits sowohl eine Unterdruck- als auch eine Drucklufteinrichtung für den Abziehkopf und andererseits erfordert diese bekannte Vorrichtung zwei getrennte Arbeitsgänge zum Abziehen des ausgelöteten Bauteils und zum Freiblasen der Bohrungen der Leiterplatte.

Der Erfindung liegt die Aufgabe zugrunde, eine Vorrichtung zum Auslöten elektronischer Bauteile aus Leiterplatten der gattungsgemässen Art zu schaffen, welche bei einfacher und in der Herstellung preiswerter Bauart das Abziehen eines ausgelöteten Bauteiles und das Entfernen von Lotresten aus den Bohrungen der Leiterplatte in einfacher Weise und in ein- und demselben Arbeitsgang von der Oberseite der Arbeitsplatte her ermöglicht.

Die Lösung dieser Aufgabe ergibt sich aus den kennzeichnenden Merkmalen des Patentanspruches 1. Hierdurch wird einerseits ein mechanisches Abziehen eines ausgelöteten Bauteiles von einer Leiterplatte ermöglicht und andererseits ein sich unverzüglich daran anschliessendes Freiblasen der Bohrungen der Leiterplatte von dort verbliebenen Lotresten. Dies wird dadurch erreicht, dass die federnde Greifzange zusammen mit dem auszulötenden Bauteil vollständig von ihrem Gehäuse umgeben ist, wobei das Gehäuse mit seinem unteren, umlaufenden Rand auf der Leiterplatte aufliegt. Sobald die Bauteilbeinchen aus den Bohrungen der Leiterplatte ausgelötet sind, zieht die unter Federwirkung stehende Zugstange das ausgelötete Bauteil mittels der federnden Greifzange weiter in das Gehäuse der federnden Greifzange hinein, woraufhin unverzüglich über die an das Gehäuse angeschlossene und mit einer Druckluftquelle verbundene Druckluftleitung Druckluft zum Freiblasen der Bohrungen in der Leiterplatte zugeführt werden kann. Die Innenwände des Gehäuses dienen dabei einerseits zur Führung der federnden Greifzange und andererseits zur Bildung eines abgedichteten Druckluftraumes, so dass die Druckluft beim Aufliegen des unteren, umlaufenden Randes des Gehäuses auf der Leiterplatte nur durch die von den Bauteilbeinchen freigewordenen Bohrungen der Leiterplatte entweichen kann, wobei diese vollständig von Lötresten gereinigt werden.

Die erfindungsgemässe Vorrichtung ist äusserst einfach und preiswert in der Herstellung, da beide Funktionen des Abziehens eines Bauteiles von der Leiterplatte und des Entfernens von Lotresten aus den Bohrungen der Leiterplatte durch ein- und dasselbe Bauteile, nämlich das Gehäuse in Verbindung mit der federnden Greifzange bewirkt werden. Beide Betätigungen erfolgen von der Oberseite der Leiterplatte her und zeitlich unverzüglich nacheinander, so dass eine schnelle Arbeitsoperation möglich ist. Im Gegensatz zum einleitend beschriebenen gattungsfremden Stand der Technik ist ein Entfernen des ausgelöteten elektronischen Bauteiles aus dem Gehäuse bzw. aus den federnden Greifzangen vor dem Freiblasen der Bohrungen der Leiterplatte nicht notwendig, wodurch kürzeste Arbeitszeiten ermöglicht werden.

Im Gegensatz zum einleitend beschriebenen gattungsgemässen Stand der Technik kann die erfindungsgemässe Vorrichtung mit einer unterhalb der Leiterplatte anzuordnenden einfachen Lötbadwelle zusammenarbeiten, ohne dass diese in teurer und aufwendiger Weise zusätzlich mit einer Einrichtung zum Entfernen von Lotresten aus den Bohrungen der Leiterplatte versehen werden muss.

Weitere vorteilhafte Ausgestaltungen der Erfindung ergeben sich aus den Unteransprüchen. In besonders bevorzugter Weise wird die erfindungsgemässe Vorrichtung quer zu und an einem Schwenkarm lösbar befestigt, der aus einer horizontalen Auslötlage in eine vertikale Bestückungslage um eine Achse schwenkbar ist. Hierbei kann das auszulötende, noch auf der Leiterplatte befindliche Bauteil in bequemer Arbeitshaltung der Bedienungsperson mittels der federnden Greifzange eingeklemmt und gleichzeitig vom Gehäuse der federnden Greifzange dichtend umschlossen werden. Nach einem Verschwenken des Schwenkarms in seine horizontale Auslötlage können die Einrichtung zum Aufschmelzen der Lötstellen und die Abzieheinrichtung sowie die Einrichtung zum Entfernen von Lotresten aus den Bohrungen der Leiterplatte nacheinander elektronisch vollautomatisch in Tätigkeit treten.

In einer ganz besonders einfachen bevorzugten Ausführungsform der Erfindung ist vorgesehen, dass dem Gehäuse für die federnde Greifzange selbst Heißluft zugeführt wird, um mit dieser die Lötstellen aufzuschmelzen. Anschliessend führt die Vorrichtung automatisch die Arbeitsoperationen Abziehen des auszulötenden Bauteils und Freiblasen der Leiterplattenbohrungen aus.

Die Erfindung ist nachfolgend anhand eines Ausführungsbeispieles einer Vorrichtung zum Auslöten elektronischer Bauteile aus Leiterplatten näher erläutert. Es zeigen :

Figur 1 eine verkleinerte Seitenansicht mit in die vertikale Bestückungslage bewegtem Schwenkarm,

Figur 2 eine Seitenansicht in etwa normaler Grösse mit in die horizontale Auslötlage gebrachtem Schwenkarm,

Figur 3 eine teilweise geschnittene Seitenansicht gemäss Fig. 2,

Figur 4 eine Seitenansicht mit einer anderen Ausführungsform einer Einrichtung zum Aufschmelzen der Lötstellen und

Figur 5 ein Blockschaltbild einer Steuerschaltung zur Betätigung der Auslötvorrichtung.

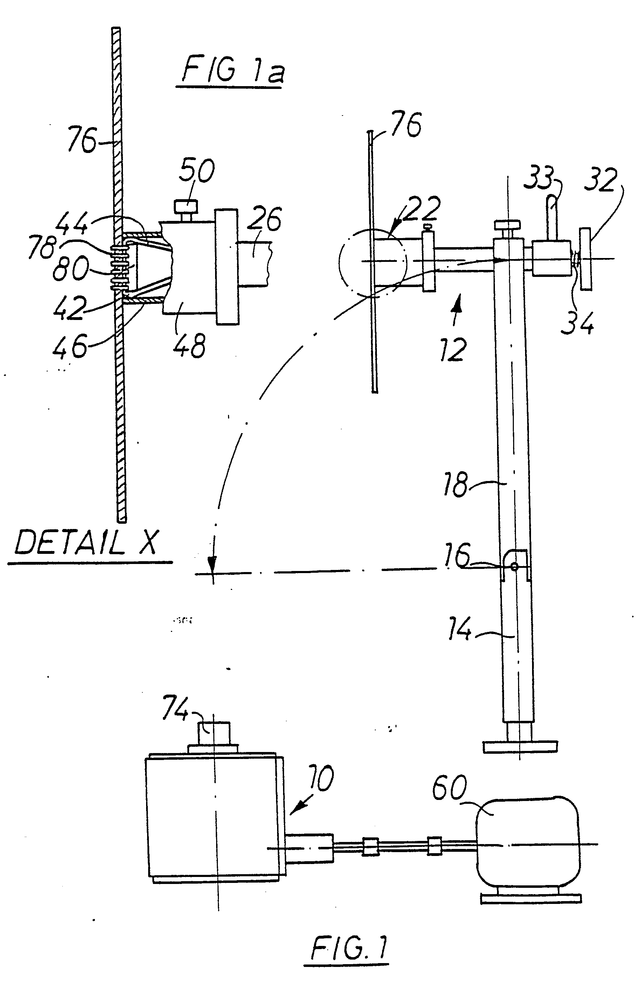

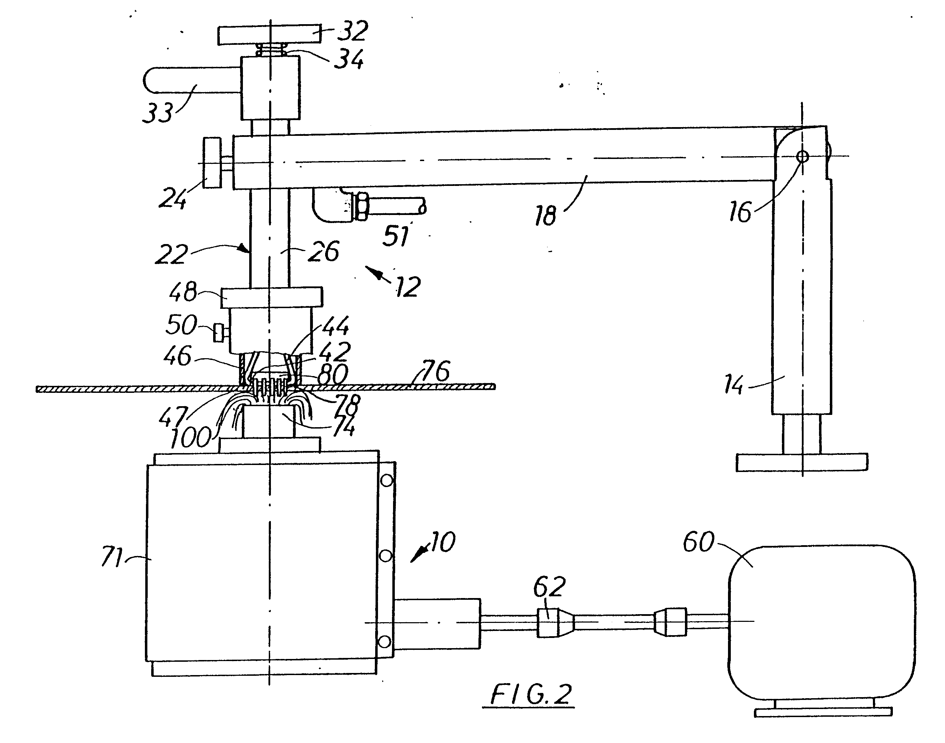

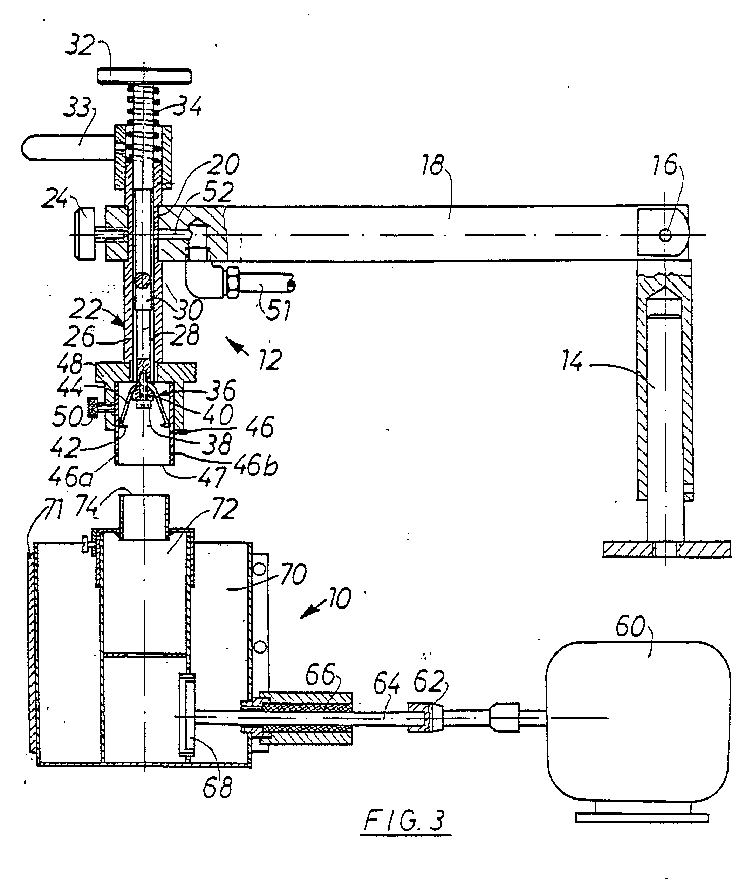

Die Vorrichtung zum Auslöten elektronischer Bauteile aus Leiterplatten umfasst im wesentlichen zwei Baueinheiten, nämlich eine Einrichtung 10 zum Aufschmelzen der Lötstellen und eine Einrichtung 12 zum Abziehen eines elektronischen Bauteiles von einer Leiterplatte und gleichzeitig zum Entfernen von Lotresten aus den Bohrungen der Leiterplatte. Die Abzieh- und Lotentfernungseinrichtung 12 ist an einem Gestell 14 angebracht, welches ein um eine horizontale Achse schwenkbares Drehgelenk 16 aufweist, an welchem ein Schwenkarm 18 befestigt ist, der wahlweise in eine vertikale Bestückungslage gemäss Fig. 1 oder in eine horizontale Auslötlage gemäss den Figuren 2 und 3 gebracht werden kann.

Am dem Schwenklager 16 entgegengesetzten Ende des Schwenkarmes 18 ist ein Aufnahmeschlitz 20 quer zur Längsachse des Schwenkarmes 18 angeordnet, welcher zur lösbaren Anordnung der Abzieheinrichtung 22 dient, welche mittels einer Schraube 24 im Schwenkarm 18 gehalten ist. Die Abzieheinrichtung 22 umfasst eine Trägerhülse 26 mit einer in dieser axial verlaufenden Längsbohrung 28. Innerhalb der Längsbohrung 28 ist eine Zugstange 30 angeordnet, welche an ihrem oberen Ende einen Betätigungsgriff 32 trägt. Zwischen dem Betätigungsgriff 32 und dem benachbarten Ende der Trägerhülse 26, die beide als Federsitz dienen, ist eine Druckfeder 34 angeordnet, welche die Zugstange 30 in ihrer oberen Betätigungslage hält, wie es in den Figuren 2 und 3 dargestellt ist. Im Bereich des oberen Endes der Trägerhülse 26 ist an dieser eine etwa rechtwinklig abstehende Griffstange 33 angebracht, die im Zusammenwirken mit dem Betätigungsgriff 32 eine Einhandbedienung für die Zugstange 30 ermöglicht.

Wie es insbesondere in Fig. 3 dargestellt ist, endet die Zugstange 30 an ihrem unteren Ende in der Darstellung gemäss den Figuren 2 und 3 in einer federnden Greifzange 36 für elektronische Bauteile. Diese federnde Greifzange 36 besteht aus einer gebogenen Blattfeder aus Federstahl, welche etwa in ihrer Mitte mittels einer Schraube 38 und einem Kurvenstück 40 am unteren Ende der Zugstange 30 festgelegt ist. Die federnde Greifzange 36 besitzt an ihren beiden Enden nach innen vorstehende Nasen 42 zum Untergreifen der Enden eines elektronischen Bauteils, wie z. B. eines IC-Gliedes, insbesondere derjenigen Enden dieses Bauteils, an denen keine Bauteilbeinchen angeordnet sind, d. h. an den Querseiten. Die federnde Greifzange 36 kann auch derart ausgebildet sein, dass diese die Längsseiten eines elektronischen Bauteiles umgreift, an welchen die Bauteilbeinchen angebracht sind.

Die beiden Arme 44 der federnden Greifzange, welche die nach innen ragenden Nasen 42 tragen, haben die Tendenz, sich nach aussen aufzubiegen und sind durch ein Gehäuse 46 zurückgehalten, dessen innere Schmalseiten als Führungen für die Arme 44 der federnden Greifzange 36 und zugleich zu deren Schliessen dienen. Das Gehäuse 46 ist an einem Gehäuseträger 48 befestigt, der fest mit der Trägerhülse 26 verbunden ist. Durch im Querschnitt unterschiedliche Gehäuse 46, die an der Zugstange 30 mittels einer Schraube 50 auswechselbar befestigbar sind, können die Querschnittsabmessungen des Gehäuses 46 an die Querschnittsabmessungen der auszulötenden und abzuziehenden elektronischen Bauteile angepasst werden.

Um die aus der unter Federwirkung stehenden Zugstange 30, der federnden Greifzange 36 und dem Gehäuse 46 gebildete Abzieheinrichtung 22 mit einer Einrichtung zum Entfernen von Lotresten aus den Bohrungen der Leiterplatte zu versehen, ist eine Fluidleitung durch die Trägerhülse 26 hindurch benachbart zur Zugstange 30 vorgesehen. Ein Fluid, wie z. B. Luft, wird über eine an eine nicht dargestellte Druckluftquelle angeschlossene Druckluftleitung 51 zugeführt, welche mit einer Bohrung 52 innerhalb des Schwenkarmes 18 in Verbindung steht. Da der Querschnitt der Zugstange 30 geringer ist als der innere Querschnitt der Durchgangsbohrung 28 innerhalb der Trägerhülse 26, kann das Fluid über die Bohrung 52 durch die Längsbohrung 28 im Gehäuse 46 zugeführt werden und kann auf das auszulötende Bauteil bzw. auf den Bereich der Leiterplatte, in welchem das ausgelötete Bauteil angeordnet war, einwirken.

Das Fluid kann Druckluft sein, welche benutzt wird, um Lotreste aus den Bohrungen in der Leiterplatte zu entfernen, in welchen die Anschlüsse der elektronischen Bauteile eingelötet waren. Das Fluid kann jedoch alternativ oder zusätzlich auch ein Heißgas sein, das dazu dient, die Lötstellen zwischen den Bauteilanschlüssen und der Leiterplatte aufzuschmelzen.

Die Einrichtung 10 zum Erzeugen von Wärme zum Aufschmelzen der Lötstellen umfasst einen Elektromotor 40, welcher über eine flexible Kupplung 62 und eine Antriebswelle 64, welche mittels eines Graphitlagers 66 gelagert ist, mit einem Propeller 68 verbunden ist. Der Propeller 68 bewirkt bei seiner Betätigung, dass ein mittels einer Heizeinrichtung 71 aufgeschmolzenes Lotbad, das in einem äusseren Behälter 70 angeordnet ist, in einem zentralen Teil 72 aufsteigt und aus einer oberen, mittleren Lotdüse 74 als Lotwelle ausfliesst und in Berührung mit der Unterseite einer Leiterplatte 76 kommt und zwar an derjenigen Stelle, an welcher ein auszulötendes Bauteil 80 mit seinen Anschlussdrähten 78 in die Leiterplatte 80 eingelötet ist. Die Lage des Propellers 68 relativ zum zentralen Teil 72 bestimmt die Höhe der Lotwelle aus dem geschmolzenen Lot. In Abhängigkeit von den Abmessungen des auszulötenden Bauteiles 80 können Düsen 74 unterschiedlicher Abmessungen eingesetzt werden.

Nachfolgend wird die Wirkungsweise der in den Fig. 1 bis 3 dargestellten Vorrichtung zum Auslöten elektronischer Bauteile aus Leiterplatten beschrieben. Das auszulötende Bauteil 80 wird manuell mit der Abzieheinrichtung 22 verbunden, indem die Leiterplatte 76 bei vertikaler Bestückungslage gemäss Fig. 1 mit dem auszulötenden Bauteil 80 gegen das Gehäuse 46 der Abzieheinrichtung 22 geführt wird. Während die Leiterplatte 76 in einer Hand gehalten wird, drückt die andere Hand der Bedienungsperson auf den Betätigungsgriff 32, während die Griffstange 33, welche fest mit der Trägerhülse 26 verbunden ist, ergriffen wird. Folglich wird ein Druck auf die Zugstange 30 gegen die Wirkung der Druckfeder 34 ausgeübt, wodurch die Zugstange 30 innerhalb der Längsbohrung 28 der Trägerhülse 26 bewegt wird.

Der Druck auf den Betätigungsgriff 32 erfolgt gegen die Wirkung der Feder 34 und ermöglicht den Armen 44 der federnden Greifzange 36, sich mit ihren nach innen gerichteten Nasen 42 aus dem Gehäuse 46 herauszuschieben und in Eingriff mit den Enden eines auszulötenden Bauteils 80 zu kommen. Eine Verminderung des Druckes auf den Betätigungsgriff 32 bewirkt eine Abziehkraft unter dem Einfluss der Feder 34, welche auf das auszulötende Bauteil 80 in Richtung weg von der Leiterplatte 76 wirkt.

Der Schwenkarm 18 wird dann um seine Schwenkachse 16 in eine horizontale Auslötlage geschwenkt, die in den Figuren 2 und 3 dargestellt ist. Der Elektromotor 60 wird betätigt, um eine Welle heißen, geschmolzenen Lots in Berührung mit der Unterseite der Leiterplatte 76 an der Stelle des auszulötenden Bauteils 80 zu bringen. Diese Lotwelle schmilzt die Lötverbindungen 78 zwischen dem Bauteil 80 und der Leiterplatte 76 auf und ermöglicht unter der Wirkung der Feder 34, das Bauteil 80 von der Leiterplatte 76 abzuziehen und vollständig in das Gehäuse 46 hineinzuziehen. Gleichzeitig oder unmittelbar mit dem Zurückziehen der Zugstange 30 wird ein Fluidstrom, wie z. B. Druckluft, über das mit seinem unteren, umlaufenden Rand 47 auf der Leiterplatte 76 aufliegende Gehäuse 46 der Leiterplatte 76 zugeführt. Dieser Luftstrom kann verschiedene Funktionen haben. Eine davon ermöglicht ein Erhitzen bzw. Aufschmelzen der Lötverbindungen. Eine andere ermöglicht eine Reinigung der Bohrungen der Leiterplatte 76 von Lotresten, um somit ein schnelles Wiedereinlöten eines neuen elektronischen Bauteiles zu ermöglichen.

Nach dem Reinigen der Leiterplatte 76 kann der Schwenkarm 18 wieder in seine vertikale Bestückungslage gebracht werden und die Leiterplatte 76 kann entfernt werden.

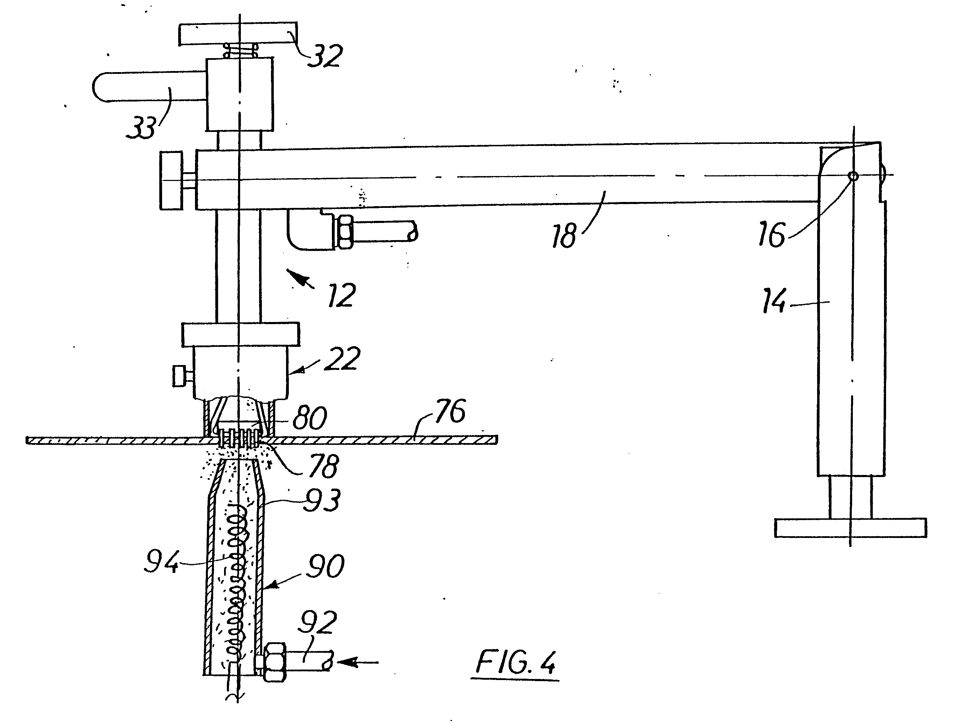

In der Fig. 4 ist eine abgewandelte Ausführungsform dargestellt, bei welcher die Einrichtung 10 zum Aufschmelzen der Lötstellen unter Wärmeeinwirkung anstelle einer Lotwelle aus geschmolzenem Lot, wie es in den Figuren 1 bis 3 dargestellt ist, eine Einrichtung 90 zur Erzeugung eines heißen Fluides umfasst. Diese Einrichtung umfasst eine nicht dargestellte Quelle für Druckgas, z. B. Luft, die über eine Leitung 92 zugeführt wird, welche mit einem Gehäuse 93 in Verbindung steht, in welchem eine Heizspule 94 angeordnet ist, um das Gas auf eine gewünschte Temperatur aufzuheizen, wie z. B. 350 °C. Ausser dieser Änderung in der Einrichtung 10 zur Erzeugung von Wärme zum Aufschmelzen der Lötstellen entspricht die übrige Vorrichtung der voranstehend beschriebenen Ausführungsform. Jedoch kann die Schwenkbarkeit des Armes 18 entfallen.

In einer nicht dargestellten alternativen Ausführungsform der Erfindung kann auch aufgeheiztes Gas allein durch die Längsbohrung 28 in der Trägerhülse 26 zugeführt werden, um die Lötstellen aufzuheizen und aufzuschmelzen. Bei dieser Ausführungsform ist keine Vorrichtung zum Aufschmelzen der Lötstellen auf der Unterseite der Leiterplatten notwendig.

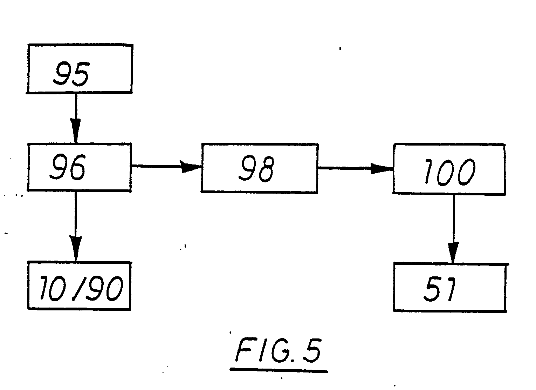

In Fig. 5 ist ein Blockdiagramm für eine Steuerschaltung dargestellt, die für die Betätigung der beschriebenen Vorrichtung zum Auslöten elektronischer Bauteile aus Leiterplatten verwendet wird. Die Anwendung von Wärme wird durch manuelle Betätigung eines Schalters 95 eingeleitet, welcher einen Timer 96 betätigt, der eingeschaltet wird, um die wärmeerzeugende Einrichtung 10 für eine genau vorherbestimmte Zeit einzuschalten. Zu einer vorherbestimmten Zeit wird in Bezug auf die Tätigkeit der wärmeerzeugenden Einrichtung 10 und insbesondere nach deren Abschaltung ein Schalter 98 zur Betätigung eines Druckluftstromes eingeschaltet. Dieser betätigt einen zweiten Timer 100, der den Druckluftstrom für eine voreingestellte Zeitspanne betätigt.

## Patentansprüche

1. Vorrichtung zum Auslöten elektronischer Bauteile aus Leiterplatten, mit einer Einrichtung zum Aufschmelzen der Lötstellen, mit einer Abzieheinrichtung aus einer mindestens teilweise von einem Gehäuse umgebenen, an einer unter Federwirkung stehenden Zugstange angebrachter, federnden Greifzange und mit einer Einrichtung zum Entfernen von Lotresten aus den Bohrungen der Leiterplatte, dadurch gekennzeichnet, dass die Einrichtung zum Entfernen von Lotresten aus dem Gehäuse (46) der federnden Greifzange (36) und einer daran angeschlossenen, mit einer Druckluftquelle verbundenen Druckluftleitung (50) gebildet ist und dass das Gehäuse (46) die federnde Greifzange (36) und das elektronische Bauteil (80) vollständig aufnimmt und mit seinem unteren, umlaufenden Rand (47) auf der Leiterplatte (80) aufliegt.

2. Vorrichtung nach Anspruch 1, dadurch gekennzeichnet, dass das Gehäuse (46) der federnden Greifzange (36) an einer rohrförmigen Trägerhülse (26) gelagert ist, in deren Längsbohrung (28) die Zugstange (30) mit Spiel geführt ist und dass die Druckluftleitung (50) an die Trägerhülse (26) angeschlossen ist.

3. Vorrichtung nach Anspruch 1 oder 2, dadurch gekennzeichnet, dass Gehäuse (46) unterschiedlicher Querschnitte an der Zugstange (30) auswechselbar befestigbar sind.

4. Vorrichtung nach einem der Ansprüche 1 bis 3, dadurch gekennzeichnet, dass die Trägerhülse (26) quer zu und an einem Schwenkarm (18) lösbar befestigt ist, der um eine Achse (16) aus einer horizontalen Auslötlage in eine vertikale Bestückungslage schwenkbar ist.

5. Vorrichtung nach einem der Ansprüche 1 bis 5, dadurch gekennzeichnet, dass als Einrichtung zum Aufschmelzen der Lötstellen eine Heißluftleitung an das Gehäuse (46) bzw. an die Trägerhülse (26) angeschlossen ist.

## Claims

1. Device for the desoldering of electronic components from printed circuit boards, having a device for melting the soldered joints, having a draw-off device comprising a resilient gripper, which is at least partially enclosed by a housing and which is fitted at a pull rod which stands under spring action, and having a device for removing solder residues from the bores of the printed circuit board, characterized in that the device for removing solder residues is formed from the housing (46) of the resilient gripper (36) and a compressed air duct (50), which is attached thereto and which is connected to a compressed air source, and in that the housing (46) entirely receives the resilient gripper (36) and the electronic component (80) and rests by its lower, circulating rim (47) on the printed circuit board (80).

2. Device according to Claim 1, characterized in that the housing (46) of the resilient gripper (36) is mounted at a tabular carrier sleeve (26), in the longitudinal bore (28) of which the pull rod (30) is guided with play, and in that the compressed air duct (50) is attached to the carrier sleeve (26).

3. Device according to Claim 1 or 2, characterized in that housings (46) of differing cross-sections are exchangeably securable to the pull rod (30).

4. Device according to one of Claims 1 to 3, characterized in that the carrier sleeve (26) is releasably secured transversely to and at a pivot arm (18), which is pivotable about an axle (16) from a horizontal desoldering position into a vertical equipping position.

5. Device according to one of Claims 1 to 5, (sic) characterized in that, as the device for melting the soldered joints, a hot air duct is attached to the housing (46) or to the carrier sleeve (26).

## Revendications

1. Dispositif pour dessouder des composants électroniques de circuits imprimés, avec une installation pour fondre les points de soudure, avec une installation d'extraction constituée d'une pince élastique de préhension entourée au moins partiellement d'un boîtier et rapportée sur une tige de traction soumise à l'action d'un ressort, et avec une installation pour enlever les résidus de soudure des perçages du circuit imprimé, dispositif caractérisé en ce que l'installation pour enlever les résidus de soudure est constituée par le boîtier (46) de la pince élastique de préhension (38) et d'une canalisation d'air comprimé (50) raccordée à ce boîtier et reliée à une source d'air comprimé, tandis que le boîtier (48) recouvre complètement la pince élastique de préhension (36) et le composant électronique (80) et s'applique par son bord inférieur périphérique (47) sur le circuit imprimé (80).

2. Dispositif selon la revendication 1, caractérisé en ce que le boîtier (46) de la pince élastique de préhension (36) est monté sur une douille porteuse tubulaire (26) dans le perçage longitudinal (28) de laquelle est guidée avec du jeu la tige de traction (30), tandis que la canalisation d'air comprimé (50) est raccordée à la douille porteuse (26).

3. Dispositif selon la revendication 1 ou 2, caractérisé en ce que des boîtiers (46) de sections transversales différentes sont susceptibles d'être fixés de façon amovible sur la tige de traction (30).

4. Dispositif selon une des revendications 1 à 3, caractérisé en ce que la douille porteuse (26) est fixée de façon amovible sur un bras pivotant (18) et transversalement par rapport à ce bras, qui est susceptible de pivoter autour d'un axe (16) à partir d'une position horizontale de dessoudage dans une position verticale d'équipement.

5. Dispositif selon une des revendications 1 à 4, caractérisé en ce que, en tant qu'installation pour fondre les points de soudure, une canalisation d'air chaud est raccordée au boîtier (46) ou bien à la douille porteuse (26).

_FIG 1a_

DETAIL X

_FIG.1_

FIG.2

FIG. 3

FIG.4

FIG.5